# EUROPEAN PATENT APPLICATION

(11) **EP 1 251 560 A1**
(43) Date of publication of application: **23.10.2002**
(21) Application number: 01958486.1
(22) Date of filing: 24.08.2001
(51) Int. Cl.: H01L 25/04

(54) **CLUSTER GLOBULAR SEMICONDUCTOR DEVICE**

(30) Priority: 28.08.2000 JP 2000256564
(71) Applicant: DAI NIPPON PRINTING CO., LTD., Tokyo 162-8001 (JP)
(72) Inventor: ABE, Yoshito, Shinjuku-ku, Tokyo 162-8001 (JP)
(74) Representative: Müller-Boré & Partner Patentanwälte
(86) International application number: JP0107281
(87) International publication number: WO02019428

(57) **Abstract**

A cluster spherical semiconductor device includes a plurality of spherical semiconductors cluster-connected to each other. In the cluster spherical semiconductor device, the spherical semiconductors are arranged in a hexagonal lattice, a dense hexagonal lattice and a body-centered cubic lattice.

## Description

### Field of the Invention

The present invention relates to a cluster spherical semiconductor device having a plurality of spherical semiconductors cluster-connected to each other.

### Related Art

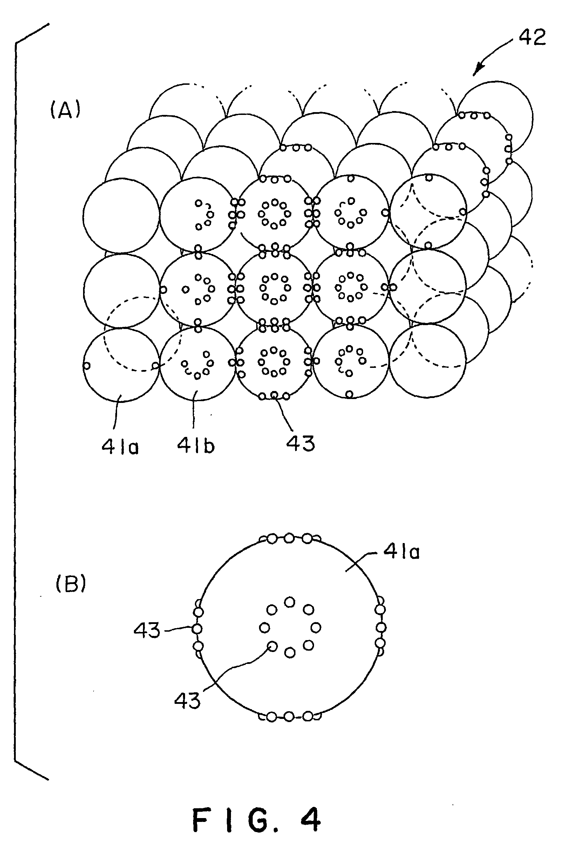

A three-dimensional arrangement of a spherical semiconductor in a conventionally proposed cluster spherical semiconductor device is a simple tetragonal cubic lattice. Fig. 4(A) shows a perspective view of this arrangement. A cluster spherical semiconductor device 42 requires an electrode for electrically connecting a plurality of spherical semiconductors 41a, 41b to each other, or for connecting the spherical semiconductors 41a, 41b to another semiconductor device or a substrate. As disclosed in Japanese Patent Application No. 031189/2000, an electrode is provided in the conventionally proposed spherical semiconductors 41, 41b ··· by disposing a spherical bump 43. The disposition thereof is shown in Fig. 4(B).

The cluster spherical semiconductor device arranged in the simple tetragonal cubic lattice arrangement as shown in Fig. 4(A) has a disadvantage about utility efficiency of a space, with a packing efficiency thereof being at most 53%. This arrangement is also unfavorable with respect to the number of electrical connections, because the number of locations where the spherical bump 43 is to be disposed is at most 6, as shown in Fig. 4(B), which is limited to front, back, right, left, up and down of the spherical semiconductors 41a, 41b, ···.

### Disclosure of the Invention

The present invention is made to solve the above disadvantages. An object thereof is to provide a cluster spherical semiconductor device in which the utility efficiency of a space in a three-dimensional arrangement of a spherical semiconductor is increased, as well as the number of electrical connections between adjacent spherical semiconductors is increased.

The above subjects are solved by the invention described hereinbelow.

A cluster spherical semiconductor device according to the present invention includes a plurality of spherical semiconductors which are cluster-connected to each other, wherein the spherical semiconductors are arranged in a hexagonal lattice.

In the cluster spherical semiconductor device, since the spherical semiconductors are arranged in a hexagonal lattice, the utility efficiency of a space in a three-dimensional arrangement of the spherical semiconductors is increased, as well as the number of electrical connections between adjacent spherical semiconductors is increased.

The cluster spherical semiconductor device according to the present invention includes a plurality of spherical semiconductors which are cluster-connected to each other, wherein the spherical semiconductors are arranged in a dense hexagonal lattice.

In the cluster spherical semiconductor device, since the spherical semiconductors are arranged in a dense hexagonal lattice, the utility efficiency of a space in a three-dimensional arrangement of the spherical semiconductors is increased, as well as the number of electrical connections between adjacent spherical semiconductors is increased.

The cluster spherical semiconductor device according to the present invention includes a plurality of spherical semiconductors which are cluster-connected to each other, wherein the spherical semiconductors are arranged in a body-centered cubic lattice.

In the cluster spherical semiconductor device, since the spherical semiconductors are arranged in a body-centered cubic lattice, the utility efficiency of a space in a three-dimensional arrangement of the spherical semiconductors is increased, as well as the number of electrical connections between adjacent spherical semiconductors is increased.

### Brief Description of the Drawings

Fig. 1 shows a hexagonal lattice arrangement of a spherical semiconductor in a cluster spherical semiconductor according to the present invention;
Fig. 2 shows a close packed hexagonal lattice arrangement of a spherical semiconductor in a cluster spherical semiconductor according to the present invention;
Fig. 3 shows a body-centered cubic lattice arrangement of a spherical semiconductor in a cluster spherical semiconductor according to the present invention; and
Fig. 4 shows a three-dimensional arrangement of a spherical semiconductor in a conventional cluster spherical semiconductor.

### Detailed Description of the Invention

Embodiments of the present invention are described hereinbelow. A spherical semiconductor is a semiconductor (semiconductor device) having an integrated circuit provided on the surface of a global body with dimension of about, for example, 1mm. A cluster-connection is to connect a plurality of semiconductors (semiconductor devices) electrically to each other, with a view to achieving an upgraded and improved performance, which can not be obtained by a single semiconductor. A cluster spherical semiconductor device includes a plurality of spherical semiconductors which are cluster-connected to each other. For example, a computer system, which is realized by cluster-connecting a plurality of spherical semiconductors having such functions as RAM (random access memory), ROM (read only memory), CPU (central processor unit), interface, etc., is composed of a cluster spherical semiconductor device.

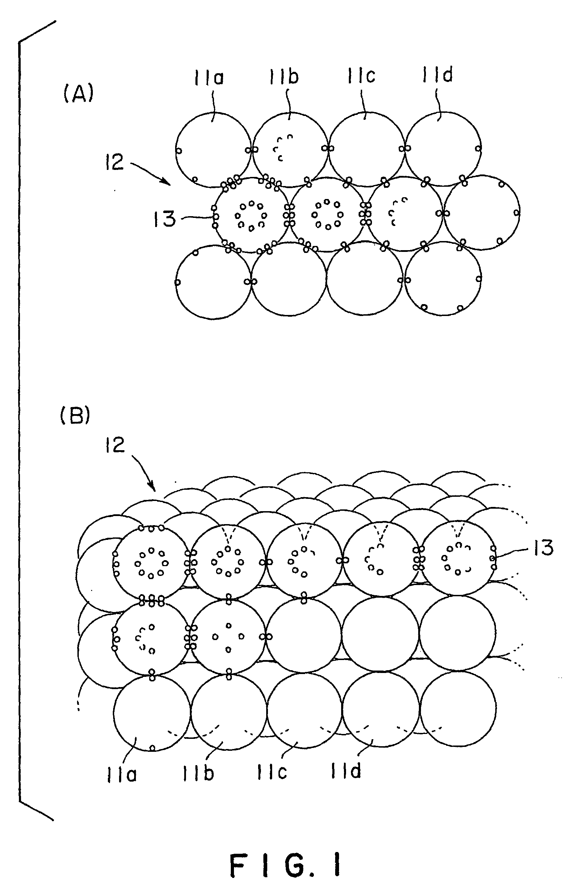

Fig. 1 shows spherical semiconductors 11a, 11b, 11c, 11d arranged in a hexagonal lattice, which is an example (example 1) of a three-dimensional arrangement of spherical semiconductors in a cluster spherical semiconductor device 12 according to the present invention. Fig. 1(A) is a top view thereof. Fig. 1(A) illustrates an arrangement of the spherical semiconductors 11a, 11b, 11c, 11d in each layer of the cluster spherical semiconductor device 12 which is composed of a layered body. As shown in Fig. 1(A), the spherical semiconductors 11a, 11b, 11c, 11d in the respective layers are arranged in a hexagonal lattice. Namely, one spherical semiconductor 11a, 11b is surrounded in contact with six spherical semiconductors 11a, 11b ··· in a layer.

Fig. 1(B) is a perspective view of the cluster semiconductor device 12. As shown in Fig. 1(B), the layers of the cluster semiconductor device 12 are so laminated that phases of the spherical semiconductors 11a, 11b ··· in the respective layers are correspondent to each other. That is, the layers are piled up so as to bring the spherical semiconductors 11a, 11b ··· in a layer disposed directly above the spherical semiconductors 11a, 11b ··· in the lower layer.

In the cluster spherical semiconductor device 12 which has the spherical semiconductors 11a, 11b ··· arranged in a hexagonal lattice as shown in Fig. 1, the packing efficiency thereof is about 60%. The respective spherical semiconductor devices 11a, 11b ··· in this arrangement have 8 positions where a spherical bump 13 is to be disposed, 6 positions of these portions being in a layer and 2 positions being up and down. That is, each spherical semiconductor 11a, 11b ··· has the spherical bump 13 at a portion in contact with the adjacent semiconductors 11a, 11b ···. As stated above, the cluster spherical semiconductor device 12 according to the present invention has advantages in the utility efficiency of a space and the number of electrical connections, in relation to the conventional cluster spherical semiconductor device 42.

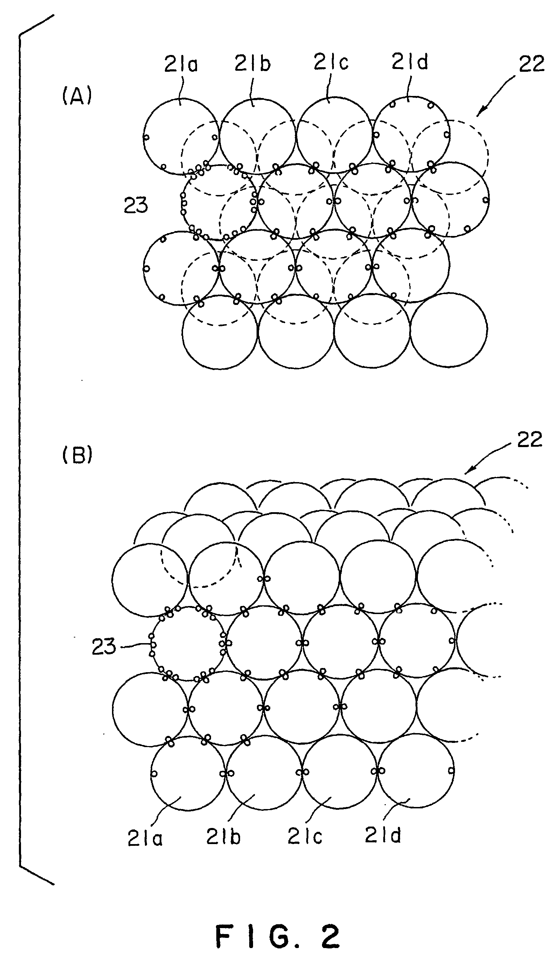

Fig. 2 shows spherical semiconductors 21a, 21b, 21c, 21d arranged in a close packed hexagonal lattice, which is an example (example 2) of a three-dimensional arrangement of spherical semiconductors in a cluster spherical semiconductor device 22 according to the present invention. Fig. 2(A) is a top view thereof. Fig. 2(A) illustrates an arrangement of the spherical semiconductors 21a, 21b ··· in each layer of the cluster spherical semiconductor device 22 of a layered body. As shown in Fig. 2(A), the spherical semiconductors 21a, 21b ··· in the respective layers are arranged in a close packed hexagonal lattice. Namely, one spherical semiconductor 21a, 21b is surrounded in contact with six spherical semiconductors 21a, 21b ··· in a layer.

Fig. 2(B) is a perspective view of the cluster semiconductor device 22. As shown in Fig. 2(B), the layers are so laminated that phases of the spherical semiconductors 21a, 21b ··· are staggered by 180 degrees. That is, the spherical semiconductors 21a, 21b ··· are piled up such that the spherical semiconductors 21a, 21b ··· of the upper layer are received in the recesses in the lower layer. Namely, the layers are laid up like a pyramid of oranges which heaped up in a fruit store.

In the cluster spherical semiconductor device 22 which has the spherical semiconductors 21a, 21b ··· arranged in a close packed hexagonal lattice as shown in Fig. 2, the packing efficiency thereof is about 74%. The respective spherical semiconductors 21a, 21b ··· in this arrangement have 12 positions where a spherical bump 23 is to be, 6 positions of these portions being in a layer and 3 positions being in the upper and lower layers respectively. As described above, the cluster spherical semiconductor device 22 according to the present invention has advantages in the utility efficiency of a space and the number of electrical connections, in relation to the conventional cluster spherical semiconductor device 42.

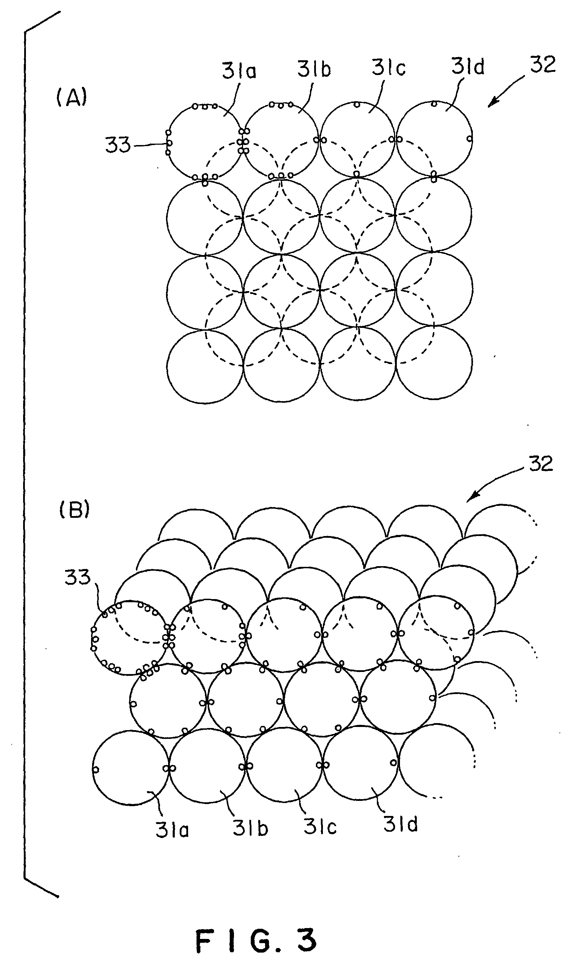

Fig. 3 shows a spherical semiconductors 31a, 31b, 31c, 31d arranged in a body-centered cubic lattice, which is an example (example 3) of a three-dimensional arrangement of spherical semiconductors in a cluster spherical semiconductor device 32 according to the present invention. Fig. 3(A) is a top view thereof. Fig. 3(A) illustrates an arrangement of the spherical semiconductors 31a, 31b ··· in each layer of the cluster spherical semiconductor device 32 of a layered body. As shown in Fig. 3(A), the spherical semiconductors 31a, 31b ··· in the respective layers are arranged in a tetragonal lattice. Namely, one spherical semiconductor is surrounded in contact with four spherical semiconductors 31a, 31b ··· in a layer.

Fig. 3(B) is a perspective view of the cluster semiconductor device 32. As shown in Fig. 3(B), the layers are so laminated that phases of the spherical semiconductors 31a, 31b are staggered by 180 degrees. That is, the spherical semiconductors are piled up such that the spherical semiconductors of the upper layer are received in the recesses in the lower layer.

In the cluster spherical semiconductor device 32 which has the spherical semiconductors 31a, 31b ··· arranged in a body-centered cubic lattice as shown in Fig. 3, the packing efficiency thereof is about 61%. The respective spherical semiconductors 31a, 31b ··· in this arrangement have 12 positions where a spherical bump 33 is to be disposed, 4 positions of these portions being in a layer and 4 positions being in the upper and lower layers respectively. As described above, the cluster spherical semiconductor device 32 according to the present invention has advantages in the utility efficiency of a space and the number of electrical connections, in relation to the conventional cluster spherical semiconductor device 42.

While the embodiments of the present invention has been described as above, the total number of the spherical semiconductors 11a, 11b, 21a, 21b, 31a, 31b ···, which are the constituents of the cluster spherical semiconductor devices 12, 22, 32, is not specifically referred, nor the total number of the layers. It is apparent that the cluster spherical semiconductor devices 12, 22, 32 having structural features of the present invention have a certain effect, although the cluster spherical semiconductor devices 12, 22, 32 compose parts of a whole semiconductor device. The present invention is not limited to the total number of spherical semiconductors or layers.

As described above, in the cluster spherical semiconductor device according to the present invention, since the spherical semiconductors are arranged in a hexagonal lattice, the utility efficiency of a space in a three-dimensional arrangement of spherical semiconductors is increased, as well as the number of electrical connections between adjacent spherical semiconductors is increased.

In the cluster spherical semiconductor device according to the present invention, since the spherical semiconductors are arranged in a close packed hexagonal lattice, the utility efficiency of a space in a three-dimensional arrangement of spherical semiconductors is increased, as well as the number of electrical connections between adjacent spherical semiconductors is increased.

In the cluster spherical semiconductor device according to the present invention, since the spherical semiconductors are arranged in a body-centered cubic lattice, the utility efficiency of a space in a three-dimensional arrangement of spherical semiconductors is increased, as well as the number of electrical connections between adjacent spherical semiconductors is increased.

## Claims

1. A cluster spherical semiconductor device comprising a plurality of spherical semiconductors which are cluster-connected to each other,
wherein said spherical semiconductors are arranged in a hexagonal lattice.

2. A cluster spherical semiconductor device comprising a plurality of spherical semiconductors which are cluster-connected to each other,
wherein said spherical semiconductors are arranged in a close packed hexagonal lattice.

3. A cluster spherical semiconductor device comprising a plurality of spherical semiconductors which are cluster-connected to each other,
wherein said spherical semiconductors are arranged in a body-centered cubic lattice.

4. The cluster spherical semiconductor device as claimed in any one of claims 1 to 3,
wherein each spherical semiconductor has a spherical bump at a portion being in contact with a spherical semiconductor adjacent thereto.
